# EUROPÄISCHE PATENTSCHRIFT

(11) **EP 3 368 829 B1**
(45) Veröffentlichungstag und Bekanntmachung des Hinweises auf die Patenterteilung: **11.12.2024**
(21) Anmeldenummer: 16781730.3
(22) Anmeldetag: 10.10.2016
(51) Int. Cl.: F24C 7/08, G01R 19/00, G01R 19/14, G01R 19/165, G01R 31/52, G01R 31/69

(54) **HAUSGERÄTEHEIZVORRICHTUNG**
DOMESTIC-APPLIANCE HEATING DEVICE
DISPOSITIF DE CHAUFFAGE D'APPAREIL MÉNAGER

(30) Priorität: 28.10.2015 DE 102015221068
(43) Veröffentlichungstag der Anmeldung: 05.09.2018
(73) Patentinhaber: BSH Hausgeräte GmbH, 81739 München (DE)
(72) Erfinder: LEGO, Dieter, 76137 Karlsruhe (DE); NAGEL, Martin, 67580 Forstheim (FR)
(86) Internationale Anmeldenummer: PCT/EP2016/074164
(87) Internationale Veröffentlichungsnummer: WO 2017/071938

(56) Entgegenhaltungen:
- EP-A1- 2 648 476
- EP-A1- 2 852 249
- WO-A1-2012/063159
- DE-A1- 102005 033 669
- DE-A1- 102010 031 020
- DE-A1- 102012 019 095
- DE-A1- 102014 206 279

## Beschreibung

Die Erfindung geht aus von einer Hausgeräteheizvorrichtung nach dem Oberbegriff des Patentanspruchs 1.

Aus dem Stand der Technik ist bereits eine Hausgeräteheizvorrichtung bekannt, die einen ersten Heizanschluss und einen zweiten Heizanschluss aufweist, die jeweils mit einem Versorgungsanschluss eines Versorgungsnetzes verbindbar sind. Zwischen dem ersten Heizanschluss und einem ersten Versorgungsanschluss ist ein erstes Schaltelement geschaltet. Um einen Heizbetriebszustand zu starten und damit das Heizelement zu beheizen, wird mittels des ersten Schaltelements ein Leitungspfad zwischen dem Heizelement und den Versorgungsanschlüssen hergestellt. Zu einer Unterbrechung oder Beendung des Heizbetriebszustands wird der Leitungspfad zwischen dem Heizelement und den Versorgungsanschlüssen mittels des ersten Schaltelements unterbrochen. Die Betätigung des ersten Schaltelements geschieht beispielsweise mittels eines Bedienelements. Zudem weist die Hausgeräteheizvorrichtung eine Messeinheit mit einem Messeingang auf, an dem in dem Heizbetriebszustand ein Potential anliegt. Um eine eindeutige Messung mittels der Messeinheit zu ermöglichen, muss eine Netzform des Versorgungsnetzes bekannt sein, an welches die Versorgungsanschlüsse angeschlossen sind. Die Netzform ist länderabhängig, weshalb abhängig von einem jeweiligen Land unterschiedliche Hausgeräteheizvorrichtung verwendet, insbesondere vertrieben, werden könnten. Bei bekannter Netzform muss zudem in einigen Ländern, wie beispielsweise in Europa oder in Japan, eine eindeutige Polung der Heizanschlüsse sichergestellt sein, da in diesen Ländern Nullleiter an einem der Versorgungsanschlüssen anliegt. Dies kann einerseits mittels einer aufwendigen Vorrichtung, die wenigstens eine Phasenerkennung, eine Steuereinheit und eine entsprechende Relaisschaltung erfordert, realisiert werden. Andererseits könnte eine entsprechende Polung der Heizanschlüsse bei einem Anschluss der Heizanschlüsse an die Versorgungsanschlüsse sichergestellt werden, insbesondere durch einen Elektriker und/oder Monteur.

Aus der DE 10 2014 206279 A1 ist bereits eine Hausgeräteheizvorrichtung mit einer Messeinheit und einer Steuereinheit bekannt, wobei anhand der an den Versorgungsanschlüssen anliegenden Potentiale die Polung der Anschlüsse ermittelt werden kann.

Die Aufgabe der Erfindung besteht insbesondere darin, eine gattungsgemäße Vorrichtung mit verbesserten Eigenschaften hinsichtlich eines geringen Aufwands bei einer Bestimmung einer an Heizanschlüssen anliegenden Netzform bereitzustellen. Die Aufgabe wird durch die Merkmale des Patentanspruchs 1 gelöst, während vorteilhafte Ausgestaltungen und Weiterbildungen der Erfindung den Unteransprüchen entnommen werden können.

Die Erfindung geht aus von einer Hausgeräteheizvorrichtung, insbesondere von einer Gargeräteheizvorrichtung, mit zumindest einem Heizelement, das zumindest zwei Heizanschlüsse aufweist, die jeweils zu einem Anschluss an einen von zumindest zwei Versorgungsanschlüssen eines Versorgungsnetzes, insbesondere eines Haushaltsnetzes, vorgesehen sind, mit zumindest einem ersten Schaltelement, das zwischen einem ersten Heizanschluss der Heizanschlüsse und einem ersten Versorgungsanschluss der Versorgungsanschlüsse geschaltet ist, mit zumindest einem zweiten Schaltelement, das zwischen einem zweiten Heizanschluss der Heizanschlüsse und einem zweiten Versorgungsanschluss der Versorgungsanschlüsse geschaltet ist, und mit einer Messeinheit, die zumindest einen Messeingang aufweist, an dem in wenigstens einem Heizbetriebszustand ein Potential anliegt.

Erfindungsgemäß ist vorgesehen, dass die Hausgeräteheizvorrichtung eine Steuereinheit aufweist, die dazu ausgelegt ist, in wenigstens einem Netzformerkennungsbetriebszustand einen Leitungspfad durch das Heizelement mittels des ersten Schaltelements bei geschlossenem zweitem Schaltelement zu unterbrechen und ein an dem Messeingang anliegendes erstes Potential bei einer Ermittlung einer an dem Heizelement anliegenden Netzform zu berücksichtigen. Unter einer "Hausgeräteheizvorrichtung" soll insbesondere zumindest ein Teil, insbesondere eine Unterbaugruppe, eines Hausgeräts, insbesondere eines Gargeräts, vorteilhaft eines Backofens, verstanden werden. Insbesondere kann die Hausgeräteheizvorrichtung auch das gesamte Hausgerät, insbesondere das gesamte Gargerät, umfassen. Unter einem "Heizelement" soll insbesondere ein Element verstanden werden, welches in dem zumindest einen Heizbetriebszustand zu einem vorzugsweise induktiven Beheizen vorgesehen ist, insbesondere mit einer Heizleistung von mindestens 100 W, insbesondere von mindestens 500 W, vorzugsweise von mindestens 1000 W, besonders vorteilhaft von mindestens 1500 W und vorzugsweise von mindestens 3000 W. Unter einem "Anschluss" eines Objekts soll insbesondere eine elektrische Kontaktstelle verstanden werden, über welche das Objekt mit einem weiteren Objekt elektrisch verbindbar ist, und an welchem in wenigstens einem Betriebszustand, insbesondere in dem Heizbetriebszustand, vorteilhaft ein elektrisches Potential anliegt. Unter einem "Schaltelement" soll insbesondere ein Element verstanden werden, das dazu vorgesehen ist, zwischen zumindest zwei Punkten, insbesondere zwischen zumindest zwei Kontakten des Schaltelements, eine elektrisch leitende Verbindung herzustellen und/oder zu trennen. Das Schaltelement ist insbesondere als elektrisches Element ausgebildet und weist vorzugsweise zumindest einen Steuerkontakt zu einem Empfang eines Steuersignals auf, wobei das Schaltelement über den Steuerkontakt betätigbar und insbesondere zwischen den Kontakten schaltbar ist, insbesondere in Abhängigkeit eines von der Steuereinheit erzeugten Steuersignals. Unter der Wendung, dass das Schaltelement "zwischen" zwei Anschlüssen geschaltet ist, soll insbesondere verstanden werden, dass ein Leitungspfad, der die Anschlüsse miteinander verbindet, über das Schaltelement führt, wobei der Leitungspfad insbesondere ausschließlich bei einer geschlossenen Schaltstellung des Schaltelements elektrischen Strom führen kann. Unter einem "Leitungspfad" soll insbesondere eine elektrisch leitfähige Verbindung verstanden werden, welche dazu vorgesehen ist, in zumindest einem Betriebszustand, insbesondere in dem Heizbetriebszustand, einen elektrischen Strom zu führen. Unter einer "Messeinheit" soll insbesondere eine Einheit verstanden werden, die dazu vorgesehen ist, einen Wert eines in dem Heizbetriebszustand an dem Messeingang anliegenden Potentials zu detektieren und die insbesondere zumindest einen Messausgang aufweist, um den detektieren Wert des an dem Messeingang anliegenden Potentials vorteilhaft an die Steuereinheit auszugeben. Unter einem "Messeingang" der Messeinheit soll insbesondere ein Anschluss der Messeinheit verstanden werden, an welchem wenigstens in dem Heizbetriebszustand ein zu detektierendes elektrisches Potential anliegt. Unter einem "Heizbetriebszustand" soll insbesondere ein Betriebszustand verstanden werden, in welchem das Heizelement von elektrischem Strom durchflossen ist, insbesondere um elektrische Leistung abzugeben. Unter einer "Steuereinheit" soll insbesondere eine elektronische Einheit verstanden werden, die vorzugsweise in einer Steuer- und/oder Regeleinheit eines Hausgeräts, insbesondere eines Gargeräts, zumindest teilweise integriert ist und die vorzugsweise dazu vorgesehen ist, wenigstens das Heizelement und/oder das erste Schaltelement und/oder das zweite Schaltelement zu steuern und/oder zu regeln. Vorzugsweise umfasst die Steuereinheit eine Recheneinheit und insbesondere zusätzlich zur Recheneinheit eine Speichereinheit mit einem darin gespeicherten Steuer- und/oder Regelprogramm, das dazu vorgesehen ist, von der Recheneinheit ausgeführt zu werden. Unter einem "Netzformerkennungsbetriebszustand" soll insbesondere ein Betriebszustand verstanden werden, in welchem eine an den Heizanschlüssen des Heizelements anliegende Netzform detektierbar ist. Insbesondere ist die Steuereinheit dazu vorgesehen, in dem Netzformerkennungsbetriebszustand das Heizelement vorteilhaft durch Öffnen des ersten Schaltelements bei geschlossenem zweiten Schaltelement zu deaktivieren, wobei insbesondere eine von dem Heizelement abgegebene Heizleistung einen Wert von wenigstens im Wesentlichen Null annimmt. Vorteilhaft ist das zweite Schaltelement als Hauptschalter ausgebildet. Erfindungsgemäß ist die Steuereinheit dazu ausgelegt, in dem Netzformerkennungsbetriebszustand das erste Schaltelement in eine geöffnete Schaltstellung und das zweite Schaltelement in eine geschlossene Schaltstellung zu bringen, wodurch insbesondere an dem Messeingang ein erstes elektrisches Potential anliegt, welches die Steuereinheit bei der Ermittlung der an dem Heizelement anliegenden Netzform berücksichtigt. Insbesondere ist die Steuereinheit dazu vorgesehen, in dem Netzformerkennungsbetriebszustand das erste Potential in der Speichereinheit der Steuereinheit zu speichern. Die Netzform definiert und/oder kennzeichnet insbesondere eine Art eines Niederspannungsnetzes und/oder einen Typ eines Niederspannungsnetzes. Beispielsweise könnte eine Netzform einen Dreiphasenwechselstrom definieren. Im Fall eines Dreiphasenwechselstroms könnte die Netzform insbesondere eine Spannung mit einem Wert von wenigstens im Wesentlichen 400 V und/oder von wenigstens im Wesentlichen 415 V und/oder von wenigstens im Wesentlichen 200 V und/oder von wenigstens im Wesentlichen 380 V definieren. Alternativ oder zusätzlich könnte eine Netzform insbesondere ein TN-System und/oder ein TT-System und/oder ein IT-System definieren. Insbesondere könnte die Netzform alternativ oder zusätzlich einen Einphasenwechselstrom definieren. Im Fall eines Einphasenwechselstroms könnte die Netzform insbesondere eine Spannung mit einem Wert von wenigstens im Wesentlichen 230 V und/oder von wenigstens im Wesentlichen 240 V und/oder von wenigstens im Wesentlichen 200 V und/oder von wenigstens im Wesentlichen 220 V definieren. Die Netzform könnte insbesondere in verschiedenen Ländern verschiedene Niederspannungsnetze definieren. Insbesondere könnte sich die Netzform länderabhängig ändern. Unter "vorgesehen" soll insbesondere speziell programmiert, ausgelegt und/oder ausgestattet verstanden werden. Darunter, dass ein Objekt zu einer bestimmten Funktion vorgesehen ist, soll insbesondere verstanden werden, dass das Objekt diese bestimmte Funktion in zumindest einem Anwendungs- und/oder Betriebszustand erfüllt und/oder ausführt.

Durch die derartige Ausgestaltung kann insbesondere ein geringer Aufwand bei einer Bestimmung einer an den Heizanschlüssen anliegenden Netzform erreicht werden. Hierdurch können vorzugsweise geringe Kosten erreicht werden. Besonders vorteilhaft kann die Hausgeräteheizvorrichtung in verschiedenen Ländern bedenkenlos an ein jeweiliges Versorgungsnetz angeschlossen werden. Weiterhin kann insbesondere ein schneller Montagevorgang und/oder Produktionsvorgang erreicht werden, und zwar sowohl bei einer Fertigung der Hausgeräteheizvorrichtung als auch bei einem Anschluss der Hausgeräteheizvorrichtung durch einen Endnutzer, welcher insbesondere auf eine Hilfe eines Elektrikers und/oder Monteurs verzichten kann. Dadurch kann zudem ein hoher Komfort für den Endnutzer bereitgestellt werden. Darüber hinaus kann vorteilhaft eine einfache, unkomplizierte Schaltung und damit insbesondere ein geringer Aufwand bei einer Wartung erreicht werden. Insbesondere kann eine kostengünstige Ermittlung einer Netzform durch einen Softwarealgorithmus erreicht werden, wobei insbesondere auf eine zusätzliche Hardware verzichtet werden kann. Die Hausgeräteheizvorrichtung und/oder ein die Hausgeräteheizvorrichtung aufweisendes Hausgerät können/kann insbesondere weltweit verwendet werden, wobei insbesondere auf eine spezielle Anpassung bezüglich Verdrahtung und/oder Elektronik und/oder Software aufgrund von unterschiedlichen Netzformen verzichtet werden kann.

Erfindungsgemäß ist vorgesehen, dass die Steuereinheit dazu ausgelegt ist, in dem Netzformerkennungsbetriebszustand einen Leitungspfad durch das Heizelement mittels des zweiten Schaltelements bei geschlossenem ersten Schaltelement zu unterbrechen und ein an dem Messeingang anliegendes zweites Potential bei der Ermittlung der an dem Heizelement anliegenden Netzform zu berücksichtigen. Insbesondere ist die Steuereinheit dazu vorgesehen, in dem Netzformerkennungsbetriebszustand das zweite Potential in der Speichereinheit der Steuereinheit zu speichern. Erfindungsgemäß ist die Steuereinheit dazu ausgelegt, in dem Netzformerkennungsbetriebszustand einen Leitungspfad durch das Heizelement mittels des ersten Schaltelements bei geschlossenem zweiten Schaltelement zu unterbrechen und ein an dem Messeingang anliegendes erstes Potential bei der Ermittlung der an dem Heizelement anliegenden Netzform zu berücksichtigen. Besonders vorteilhaft ist die Steuereinheit dazu vorgesehen, in dem Netzformerkennungsbetriebszustand einen Leitungspfad durch das Heizelement zunächst mittels eines beliebigen der Schaltelemente bei geschlossenem weiteren Schaltelement und anschließend mittels des weiteren Schaltelements bei geschlossenem beliebigen Schaltelement zu unterbrechen und beide an dem Messeingang anliegende Potentiale bei der Ermittlung der an dem Heizelement anliegenden Netzform zu berücksichtigen. Die Steuereinheit ist erfindungsgemäß dazu ausgelegt, in dem Netzformerkennungsbetriebszustand das erste Potential und das zweite Potential miteinander zu vergleichen und eine Differenz aus dem ersten Potential und dem zweiten Potential zu berechnen. Insbesondere ist die Steuereinheit dazu vorgesehen, in dem Netzformerkennungsbetriebszustand einen Betrag der Differenz aus dem ersten Potential und dem zweiten Potential zu ermitteln und insbesondere den Betrag der Differenz aus dem ersten Potential und dem zweiten Potential mit einem in der Speichereinheit der Steuereinheit gespeicherten Differenz-Referenzpotential zu vergleichen. Dadurch kann insbesondere auf einfache Weise die Netzform ermittelt werden. Insbesondere können die an den Heizanschlüssen anliegenden Potentiale getrennt behandelt und/oder voneinander unterschieden werden. Besonders vorteilhaft kann anhand von zweier Messungen jegliche Art von Netzform erkannt werden.

Zudem wird vorgeschlagen, dass die Steuereinheit dazu ausgelegt ist, in dem Netzformerkennungsbetriebszustand anhand der an dem Messeingang anliegenden Potentiale ein Anliegen eines Nullleiters an einem der Versorgungsanschlüsse zu erkennen. Die Steuereinheit ist insbesondere dazu vorgesehen, in dem Netzformerkennungsbetriebszustand in dem Fall, dass der Betrag der Differenz aus dem ersten Potential und dem zweiten Potential größer ist als das in der Speichereinheit der Steuereinheit gespeicherte Differenz-Referenzpotential, auf ein Anliegen eines Nullleiters an einem der Versorgungsanschlüsse zu schließen. Dadurch kann insbesondere durch einfache Softwareoperationen zwischen verschiedenen Netzformen unterschieden werden.

Weiterhin wird vorgeschlagen, dass die Steuereinheit dazu ausgelegt ist, insbesondere im Fall eines Anliegens eines Nullleiters an einem der Versorgungsanschlüsse in wenigstens einem Polungsdetektionsbetriebszustand den Versorgungsabschluss, an welchem der Nullleiter anliegt, insbesondere anhand der an dem Messeingang anliegenden Potentiale, zu ermitteln. Im Fall eines Anliegens eines Nullleiters an einem der Versorgungsanschlüsse ist die Steuereinheit insbesondere dazu vorgesehen, in dem Polungsdetektionsbetriebszustand das erste Potential mit einem in der Speichereinheit der Steuereinheit gespeicherten unteren Referenzpotential zu vergleichen. Insbesondere ist die Steuereinheit dazu vorgesehen, in dem Polungsdetektionsbetriebszustand in dem Fall, dass das erste Potential kleiner ist als das untere Referenzpotential, ein Anliegen eines Nullleiters an dem ersten Heizanschluss und insbesondere zusätzlich ein Anliegen eines Phasenleiters an dem zweiten Heizanschluss zu erkennen. Die Steuereinheit ist insbesondere dazu vorgesehen, in dem Polungsdetektionsbetriebszustand das erste Potential mit einem in der Speichereinheit der Steuereinheit gespeicherten oberen Referenzpotential zu vergleichen. Insbesondere ist die Steuereinheit dazu vorgesehen, in dem Polungsdetektionsbetriebszustand in dem Fall, dass das erste Potential größer ist als das obere Referenzpotential, ein Anliegen eines Nullleiters an dem zweiten Heizanschluss und insbesondere zusätzlich ein Anliegen eines Phasenleiters an dem ersten Heizanschluss zu erkennen. Alternativ oder zusätzlich ist die Steuereinheit insbesondere dazu vorgesehen, im Fall eines Anliegens eines Nullleiters an einem der Versorgungsanschlüsse in dem Polungsdetektionsbetriebszustand das zweite Potential mit einem in der Speichereinheit der Steuereinheit gespeicherten unteren Referenzpotential zu vergleichen. Insbesondere ist die Steuereinheit dazu vorgesehen, in dem Polungsdetektionsbetriebszustand in dem Fall, dass das zweite Potential kleiner ist als das untere Referenzpotential, ein Anliegen eines Nullleiters an dem zweiten Heizanschluss und insbesondere zusätzlich ein Anliegen eines Phasenleiters an dem ersten Heizanschluss zu erkennen. Die Steuereinheit ist insbesondere dazu vorgesehen, in dem Polungsdetektionsbetriebszustand das zweite Potential mit einem in der Speichereinheit der Steuereinheit gespeicherten oberen Referenzpotential zu vergleichen. Insbesondere ist die Steuereinheit dazu vorgesehen, in dem Polungsdetektionsbetriebszustand in dem Fall, dass das zweite Potential größer ist als das obere Referenzpotential, ein Anliegen eines Nullleiters an dem ersten Heizanschluss und insbesondere zusätzlich ein Anliegen eines Phasenleiters an dem zweiten Heizanschluss zu erkennen. Unter einem "Polungsdetektionsbetriebszustand" soll insbesondere ein Betriebszustand verstanden werden, in welchem eine an den Heizanschlüssen des Heizelements anliegende Polungsrichtung detektierbar ist.

Insbesondere ist die Steuereinheit dazu vorgesehen, in dem Polungsdetektionsbetriebszustand das Heizelement vorteilhaft durch Öffnen des ersten Schaltelements bei geschlossenem zweiten Schaltelement zu deaktivieren, wobei insbesondere eine von dem Heizelement abgegebene Heizleistung einen Wert von wenigstens im Wesentlichen Null annimmt. Alternativ oder zusätzlich ist die Steuereinheit insbesondere dazu vorgesehen, in dem Polungsdetektionsbetriebszustand das Heizelement vorteilhaft durch Öffnen des zweiten Schaltelements bei geschlossenem ersten Schaltelement zu deaktivieren, wobei insbesondere eine von dem Heizelement abgegebene Heizleistung einen Wert von wenigstens im Wesentlichen Null annimmt. Dadurch kann insbesondere unabhängig von einer Steckrichtung eines Gerätesteckers in einer Anschlussdose des Versorgungsnetzes ein Betrieb des Hausgeräts und/oder insbesondere eine frühzeitige Erkennung einer Überhitzung des Heizelements ermöglicht werden.

Die Steuereinheit ist insbesondere dazu vorgesehen, in dem Netzformerkennungsbetriebszustand in dem Fall, dass der Betrag der Differenz aus dem ersten Potential und dem zweiten Potential kleiner ist als das in der Speichereinheit der Steuereinheit gespeicherte Differenz-Referenzpotential, auf eine Abwesenheit eines Nullleiters an einem der Versorgungsanschlüsse und insbesondere ein Anliegen von Phasenleitern zu schließen. Vorzugsweise ist die Steuereinheit dazu ausgelegt, in dem Netzformerkennungsbetriebszustand anhand der an dem Messeingang anliegenden Potentiale ein Anliegen von Phasenleitern an den Versorgungsanschlüssen zu erkennen. Insbesondere ist die Steuereinheit dazu vorgesehen, in dem Netzformerkennungsbetriebszustand das erste Potential und/oder, insbesondere und, das zweite Potential auf Gültigkeit, insbesondere zu einer Verwendung bei einer Erkennung eines Anliegens von Phasenleitern an den Versorgungsanschlüssen, zu prüfen. Die Steuereinheit ist insbesondere dazu vorgesehen, in dem Netzformerkennungsbetriebszustand das erste Potential und/oder, insbesondere und, das zweite Potential mit einem in der Speichereinheit der Steuereinheit gespeicherten Gültigkeitsbereich zu vergleichen und insbesondere in dem Fall, dass das erste Potential und/oder, insbesondere und, das zweite Potential innerhalb des Gültigkeitsbereichs liegen/liegt, auf ein Anliegen von Phasenleitern an den Versorgungsanschlüssen zu schließen. Dadurch kann insbesondere ein hoher Komfort für einen Bediener erreicht und/oder in einfacher Weise ein Anliegen von Phasenleitern an den Versorgungsanschlüssen erkannt werden.

Die Steuereinheit ist insbesondere dazu vorgesehen, in dem Netzformerkennungsbetriebszustand insbesondere in dem Fall, dass das erste Potential und/oder, insbesondere und, das zweite Potential außerhalb des Gültigkeitsbereichs liegen/liegt, auf eine Verwendung des ersten Potentials und/oder, insbesondere und, des zweiten Potentials bei der Erkennung eines Anliegens von Phasenleitern an den Versorgungsanschlüssen zu verzichten. Vorzugsweise ist die Steuereinheit dazu ausgelegt, in dem Netzformerkennungsbetriebszustand, insbesondere in dem Fall, dass das erste Potential und/oder, insbesondere und, das zweite Potential außerhalb des Gültigkeitsbereichs liegen/liegt, anhand der an dem Messeingang anliegenden Potentiale zumindest einen Gerätedefekt zu erkennen. Dadurch kann insbesondere eine hohe Sicherheit für einen Bediener erreicht werden.

Weiterhin wird vorgeschlagen, dass die Steuereinheit dazu ausgelegt ist, in dem Netzformerkennungsbetriebszustand anhand der ermittelten Netzform einen Abschaltgrenzwert für das Heizelement zu ermitteln. In der Speichereinheit der Steuereinheit sind insbesondere zumindest zwei, vorteilhaft zumindest drei, besonders vorteilhaft zumindest vier und vorzugsweise mehrere verschiedene Abschaltgrenzwerte für das Heizelement gespeichert. Insbesondere ist ein jeweiliger Abschaltgrenzwert einer Netzform zugeordnet. Die Steuereinheit ist insbesondere dazu vorgesehen, in dem Netzformerkennungsbetriebszustand einen der ermittelten Netzform zugeordneten Abschaltgrenzwert zu ermitteln und insbesondere den ermittelten Abschaltgrenzwert für das Heizelement in dem Heizbetriebszustand zu berücksichtigen. Dadurch kann das Heizelement insbesondere unabhängig von einer an den Heizanschlüssen anliegenden Netzform vor einer Überhitzung geschützt werden, wodurch insbesondere eine langlebige Ausgestaltung erzielt werden kann.

Ferner wird vorgeschlagen, dass die Hausgeräteheizvorrichtung zumindest ein Sensorelement aufweist, das in dem Heizbetriebszustand zu einer Detektion eines Leckstroms aus dem Heizelement ausgelegt ist. Unter einem "Sensorelement" soll insbesondere ein Element verstanden werden, das dazu vorgesehen ist, in dem Heizbetriebszustand einen aus dem Heizelement austretenden elektrischen Strom, insbesondere einen Leckstrom, aufzunehmen und vorteilhaft an zumindest eine weitere Einheit, insbesondere an die Messeinheit, weiterzuleiten. Unter einem "Leckstrom" aus dem Heizelement soll insbesondere ein elektrischer Strom verstanden werden, welcher sich insbesondere von einem über einen der Heizanschlüsse aus dem Heizelement austretenden elektrischen Strom unterscheidet und welcher aus dem Heizelement über wenigstens einen Pfad austritt, der insbesondere von einer elektrischen Verbindung zwischen einem der Heizanschlüsse mit einem der Versorgungsanschlüsse abweicht und vorteilhaft in wenigstens einem Betriebszustand einen hochohmigen Leitungspfad darstellt, insbesondere mit Widerstandswerten in einem Bereich von einigen bis mehreren MΩ. Dadurch kann insbesondere eine präzise Detektion des Leckstroms und/oder eine frühzeitige Fehlererkennung erreicht werden. Darüber hinaus kann durch Detektion des Leckstroms insbesondere eine Temperatur des Heizelements ermittelt werden.

Beispielsweise könnte die Steuereinheit dazu vorgesehen sein, bei einer Detektion eines Leckstroms aus dem Heizelement sofort eine Notabschaltung durch Deaktivierung des Heizelements, insbesondere mittels des ersten Schaltelements und/oder vorteilhaft mittels des zweiten Schaltelements, auszuführen. Vorzugsweise ist die Steuereinheit dazu ausgelegt, in dem Heizbetriebszustand zumindest eine von dem Leckstrom des Heizelements abhängige Kenngröße zu ermitteln. Beispielsweise könnte die Kenngröße einen Wert des Leckstroms aufweisen. Ebenfalls denkbar ist, dass die Kenngröße eine Stelle aufweist, an welcher der Leckstrom aus dem Heizelement austritt. Vorzugsweise weist die Kenngröße eine Temperatur des Heizelements auf. Hierdurch kann vorteilhaft eine hohe Sicherheit in dem Heizbetriebszustand erreicht werden. Weiterhin kann besonders vorteilhaft eine Überhitzung des Heizelements frühzeitig erkannt und insbesondere Gegenmaßnahmen eingeleitet werden.

Weiterhin wird vorgeschlagen, dass wenigstens in dem Heizbetriebszustand zumindest zwei parallele Leitungspfade von einem der Versorgungsanschlüsse zu dem Messeingang führen, wobei ein erster Leitungspfad der Leitungspfade einen Bereich zwischen dem Heizelement und dem Sensorelement aufweist, durch den der Leckstrom fließt. Dadurch kann insbesondere eine Polung des Heizelements unabhängig von einem Heizbetriebszustand ermittelt werden, wodurch eine hohe Präzision erreicht werden kann. Ist die Steuereinheit dazu ausgelegt, in dem Heizbetriebszustand die an dem Heizelement anliegende Netzform bei einer Ermittlung der von dem Leckstrom des Heizelements abhängigen Kenngrößen zu berücksichtigen, kann insbesondere eine präzise Ermittlung der von dem Leckstrom des Heizelements abhängigen Kenngrößen, insbesondere der Temperatur des Heizelements, erreicht werden.

Beispielsweise könnte das Heizelement als insbesondere gewickelter Leiter, vorteilhaft als gewickelter Draht, ausgebildet sein. Vorzugsweise ist das Heizelement als Schicht ausgebildet. Unter einer "Schicht" soll insbesondere eine Ausgestaltung eines Objekts verstanden werden, bei welcher ein kleinster, das Objekt gerade noch umschließender Quader eine kürzeste Kante und zwei lange Kanten aufweist, wobei eine kürzere Kante der zwei langen Kanten mindestens 5 Mal, insbesondere mindestens 10 Mal, vorteilhaft mindestens 15 Mal und besonders vorteilhaft mindestens 20 Mal so groß ist wie die kürzeste Kante des Quaders. Die Schicht weist insbesondere eine wenigstens im Wesentlichen gleichbleibende Materialstärke auf, welche vorteilhaft einen Wert von maximal 5 mm, insbesondere von maximal 1 mm, vorteilhaft von maximal 0,5 mm und besonders vorteilhaft von maximal 0,1 mm annimmt. Unter der Wendung, dass die Schicht eine wenigstens "im Wesentlichen gleichbleibende Materialstärke" aufweist, soll insbesondere verstanden werden, dass sich ein Betrag der Materialstärke im Bereich der Schicht um maximal 20 %, insbesondere um maximal 10 % und vorteilhaft um maximal 5 % ändert. Das Heizelement kann insbesondere als ein Induktionsheizelement ausgebildet sein. Vorzugsweise ist das Heizelement als ein Strahlungsheizelement und/oder besonders vorteilhaft als ein Widerstandsheizelement ausgebildet. Dadurch kann insbesondere eine kompakte Bauweise erreicht werden. Weiterhin können geringe Kosten erreicht werden.

Beispielsweise könnte das Sensorelement als insbesondere gewickelter Leiter, vorteilhaft als gewickelter Draht, ausgebildet sein. Vorzugsweise ist das Sensorelement als Schicht ausgebildet, wodurch insbesondere eine platzsparende Ausgestaltung erreicht werden kann.

Vorteilhaft bilden das Heizelement und das Sensorelement gemeinsam einen Kondensator aus, wodurch insbesondere eine präzise Detektion des aus dem Heizelement austretenden Leckstroms erreicht werden kann. Insbesondere im Falle einer Ausgestaltung des Heizelements und des Sensorelements als Schicht bilden beide zusammen vorzugsweise einen Plattenkondensator aus.

Zudem wird vorgeschlagen, dass die Hausgeräteheizvorrichtung zumindest ein Dielektrikum aufweist, das wenigstens teilweise zwischen dem Heizelement und dem Sensorelement angeordnet ist und einen temperaturabhängigen spezifischen Widerstand aufweist, wobei die Steuereinheit dazu vorgesehen ist, den temperaturabhängigen spezifischen Widerstand des Dielektrikums zu einer Ermittlung der Kenngröße auszunutzen. Der temperaturabhängige spezifische Widerstand des Dielektrikums ändert sich insbesondere unterhalb eines Schwellwerts, insbesondere von wenigstens im Wesentlichen 200°C und/oder von wenigstens im Wesentlichen 300°C, nur geringfügig, insbesondere um maximal 5 %, vorteilhaft um maximal 1 %, besonders vorteilhaft um maximal 0,5 % und vorzugsweise um maximal 0,1 % eines Betrags des spezifischen Widerstands bei einer Temperatur von Null Grad Celsius. Bei Temperaturen oberhalb des Schwellwerts nimmt ein Widerstandswert des temperaturabhängigen spezifischen Widerstands des Dielektrikums stark ab, wobei der Widerstandswert des Dielektrikums bei Temperaturen oberhalb des Schwellwerts insbesondere einen Widerstandswert von maximal 70 %, vorteilhaft von maximal 50 %, besonders vorteilhaft von maximal 30 % und vorzugsweise von maximal 10 % eines Widerstandswerts bei Temperaturen unterhalb des Schwellwerts einen Widerstandswert aufweist, und wobei der Wert des temperaturabhängigen spezifischen Widerstands beispielsweise einen linearen und/oder exponentiellen Verlauf annehmen könnte. Unter der Wendung, dass die Steuereinheit dazu vorgesehen ist, den temperaturabhängigen spezifischen Widerstand des Dielektrikums zu einer Ermittlung der Kenngröße "auszunutzen", soll insbesondere verstanden werden, dass die Steuereinheit dazu vorgesehen ist, aus Kenntnis eines in dem Heizbetriebszustand an dem Messeingang anliegenden Potentials einen aus dem Heizelement austretenden Leckstrom zu ermitteln und insbesondere aus dem ermittelten aus dem Heizelement austretenden Leckstrom Rückschlüsse auf einen aktuellen Widerstandswert des Dielektrikums zu ziehen und vorteilhaft aus Kenntnis des in der Speichereinheit gespeicherten Verlaufs des temperaturabhängigen spezifischen Widerstands des Dielektrikums die Kenngröße zu ermitteln. Dadurch kann insbesondere eine exakte Ermittlung der Kenngröße erreicht werden. Darüber hinaus kann vorteilhaft eine preiswerte Ausgestaltung erreicht werden.

Ein besonders geringer Aufwand bei einer Bestimmung einer an den Heizanschlüssen anliegenden Netzform kann erreicht werden durch ein Hausgerät, insbesondere durch ein Gargerät, mit zumindest einer erfindungsgemäßen Hausgeräteheizvorrichtung.

Der Aufwand bei einer Bestimmung einer an den Heizanschlüssen anliegenden Netzform kann weiter reduziert werden durch ein Verfahren zu einem Betrieb einer erfindungsgemäßen Hausgeräteheizvorrichtung mit zumindest einem Heizelement, das zumindest zwei Heizanschlüsse aufweist, die jeweils zu einem Anschluss an einen von zumindest zwei Versorgungsanschlüssen eines Versorgungsnetzes vorgesehen sind, mit zumindest einem ersten Schaltelement, das zwischen einem ersten Heizanschluss der Heizanschlüsse und einem ersten Versorgungsanschluss der Versorgungsanschlüsse geschaltet ist, mit zumindest einem zweiten Schaltelement, das zwischen einem zweiten Heizanschluss der Heizanschlüsse und einem zweiten Versorgungsanschluss der Versorgungsanschlüsse geschaltet ist, und mit einer Messeinheit, die zumindest einen Messeingang aufweist, an dem in wenigstens einem Heizbetriebszustand ein Potential anliegt, wobei in wenigstens einem Netzformerkennungsbetriebszustand ein Leitungspfad durch das Heizelement mittels des ersten Schaltelements bei geschlossenem zweiten Schaltelement unterbrochen und ein an dem Messeingang anliegendes erstes Potential bei einer Ermittlung einer an dem Heizelement anliegenden Netzform berücksichtigt wird, wobei in dem wenigstens einen Netzformerkennungsbetriebszustand ein Leitungspfad durch das Heizelement mittels des zweiten Schaltelements bei geschlossenem ersten Schaltelement unterbrochen wird und ein an dem Messeingang anliegendes zweites Potential bei der Ermittlung der an dem Heizelement anliegenden Netzform berücksichtigt wird, wobei in dem wenigstens einen Netzformerkennungsbetriebszustand das erste und das zweite Potential miteinander verglichen werden und eine Differenz aus dem ersten und dem zweiten Potential berechnet wird.

Die Hausgeräteheizvorrichtung soll hierbei nicht auf die oben beschriebene Anwendung und Ausführungsform beschränkt sein. Insbesondere kann die Hausgeräteheizvorrichtung zu einer Erfüllung einer hierin beschriebenen Funktionsweise eine von einer hierin genannten Anzahl von einzelnen Elementen, Bauteilen und Einheiten abweichende Anzahl aufweisen.

Weitere Vorteile ergeben sich aus der folgenden Zeichnungsbeschreibung. In der Zeichnung ist ein Ausführungsbeispiel der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: ein Hausgerät mit einer Hausgeräteheizvorrichtung in einer schematischen perspektivischen Darstellung,
- Fig. 2: ein Heizelement, ein Dielektrikum, ein Sensorelement, ein weiteres Dielektrikum sowie ein Basiselement der Hausgeräteheizvorrichtung in einer schematischen Schnittdarstellung,
- Fig. 3: ein schematisches Schaltbild der Hausgeräteheizvorrichtung in einem Netzformerkennungsbetriebszustand in einer schematischen Darstellung,
- Fig. 4: ein schematisches Schaltbild der Hausgeräteheizvorrichtung in einem Heizbetriebszustand in einer schematischen Darstellung und
- Fig. 5: ein Diagramm eines Verfahrens zu einem Betrieb der Hausgeräteheizvorrichtung in einer schematischen Darstellung.

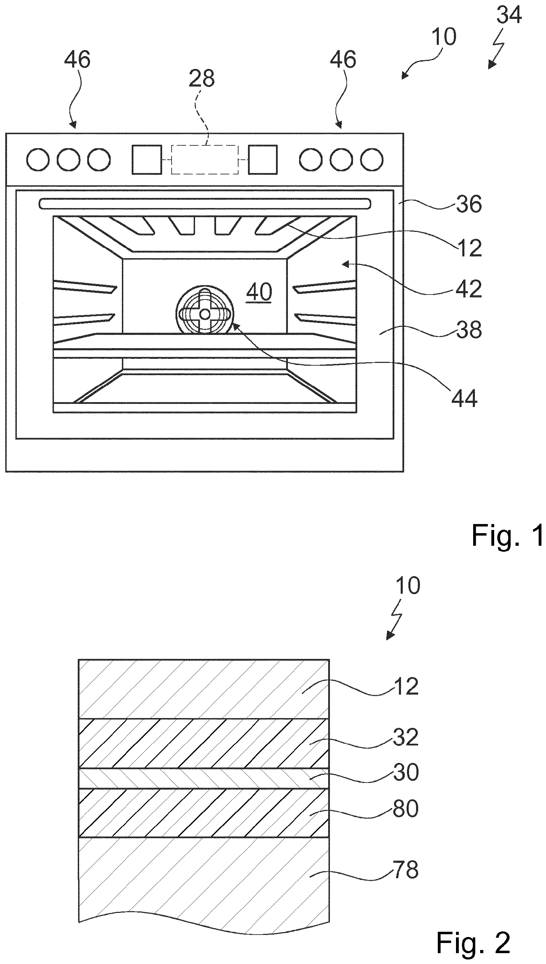

Fig. 1 zeigt ein Hausgerät 34, das als ein Gargerät ausgebildet ist, mit einer Hausgeräteheizvorrichtung 10, die als eine Gargeräteheizvorrichtung ausgebildet ist. Beispielsweise könnte das Hausgerät 34 als Dampfgarer und/oder als Induktionsofen und/oder als Herd und/oder als Wasserkocher und/oder als Kaffeemaschine und/oder als Toaster und/oder als Tepan-Yaki-Platte ausgebildet sein. Im vorliegenden Fall ist das Hausgerät 34 als ein Backofen ausgebildet.

Das Hausgerät 34 weist ein Gehäuse 36 auf, das eine äußere Begrenzung insbesondere des Hausgeräts 34 ausbildet. An einer in einem eingebauten Zustand einem Bediener zugewandten Frontseite des Gehäuses 36 weist das Gehäuse 36 eine Gerätetür 38 auf.

Die Gerätetür 38 ermöglicht einen Zugang zu einem in dem Gehäuse 36 befindlichen Garraum 40. Das Hausgerät 34 weist eine Muffel 42 auf, die den Garraum 40 begrenzt. Die Muffel 42 bildet eine seitliche Begrenzung des Garraums 40 aus. Zu einer Belüftung des Garraums 40 weist das Hausgerät 34 ein Gebläse 44 auf, welches an einer der Gerätetür 38 abgewandten Rückseite angeordnet ist.

Zu einer Erhitzung des Garraums 40 weist die Hausgeräteheizvorrichtung 10 ein Heizelement 12 auf. Alternativ zu einer Ausgestaltung mit einem einzigen Heizelement könnte die Hausgeräteheizvorrichtung auch eine andere Anzahl an Heizelementen umfassen. Beispielsweise könnte die Hausgeräteheizvorrichtung zwei Heizelemente aufweisen. Hierbei könnten die Heizelemente an einer Oberseite und an einer Unterseite der Muffel angeordnet sein. Alternativ könnten beide Heizelemente auf derselben Seite der Muffel angeordnet sein. Ein erstes Heizelement der Heizelemente könnte an der Oberseite angeordnet und zu einer Erzeugung von Oberhitze ausgebildet sein. Ein zweites Heizelement der Heizelemente könnte an der Unterseite angeordnet und zu einer Erzeugung von Unterhitze ausgebildet sein. Alternativ oder zusätzlich könnten seitlich an der Muffel, insbesondere an Seitenwänden der Muffel, angeordnete Heizelemente vorgesehen sein. Beispielsweise könnte das Heizelement als ein Induktionsheizelement und/oder als ein Strahlungsheizelement ausgebildet sein. Im vorliegenden Ausführungsbeispiel ist das Heizelement 12 als ein Widerstandsheizelement ausgebildet.

Zu einer Eingabe und/oder Auswahl von Betriebsparametern weist die Hausgeräteheizvorrichtung 10 eine Bedieneinheit 46 auf (vgl. Fig. 1). Beispielsweise könnte der Betriebsparameter eine Garzeit und/oder ein Garprogramm und/oder eine Heizleistungsstufe aufweisen. Insbesondere ist ein Betriebsparameter eine Temperatur, vorteilhaft eine Solltemperatur, wobei die Bedieneinheit 46 zu einer Eingabe und/oder Veränderung eines Werts einer Solltemperatur des Garraums 40 vorgesehen ist. Die Bedieneinheit 46 ist an der Frontseite angeordnet. Die Bedieneinheit 46 weist insbesondere eine Anzeigeeinheit auf und ist vorteilhaft zu einer Ausgabe eines Werts vorgesehen.

Die Hausgeräteheizvorrichtung 10 weist eine Steuereinheit 28 auf, die in Abhängigkeit der mittels der Bedieneinheit 46 eingegebenen und/oder ausgewählten Bedienparameter Aktionen ausführt und/oder Einstellungen vornimmt und/oder verändert. Die Steuereinheit 28 ist zu einer Steuerung und Regelung des Heizelements 12 vorgesehen. Die Hausgeräteheizvorrichtung 10 weist einen Sensor (nicht dargestellt) auf, der zu einer Detektion einer Ist-Temperatur des Garraums 40 vorgesehen ist. Alternativ ist denkbar, dass die Hausgeräteheizvorrichtung mehrere Sensoren aufweist.

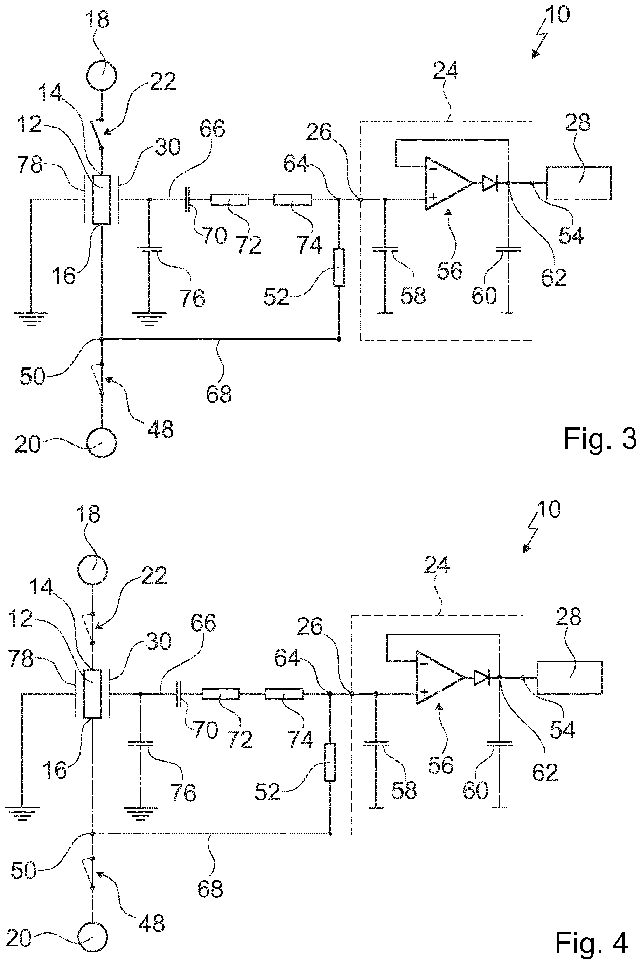

Zu einer Versorgung des Heizelements 12 mit Energie weist das Heizelement 12 zwei Heizanschlüsse 14, 16 auf (vgl. Fig. 3 und 4). Jeder der Heizanschlüsse 14, 16 ist zu einem Anschluss an einen Versorgungsanschluss 18, 20 eines Versorgungsnetzes vorgesehen. Alternativ ist denkbar, dass die Hausgeräteheizvorrichtung eine Leistungsversorgung aufweist, die zu einer Versorgung des Heizelements mit Energie vorgesehen ist. Bei der Leistungsversorgung könnte es sich um eine Umrichterschaltung, insbesondere mit zumindest einem Gleich- und/oder Wechselrichter, handeln. Ferner könnte die Leistungsversorgung eine Verbindung zu einem Versorgungsnetz, insbesondere einem Stromversorgungsnetz, aufweisen.

Ein erster Heizanschluss 14 der Heizanschlüsse 14, 16 und ein erster Versorgungsanschluss 18 der Versorgungsanschlüsse 18, 20 sind miteinander elektrisch verbunden. Ein zweiter Heizanschluss 16 der Heizanschlüsse 14, 16 und ein zweiter Versorgungsanschluss 20 der Versorgungsanschlüsse 18, 20 sind miteinander elektrisch verbunden. Die Hausgeräteheizvorrichtung 10 weist ein erstes Schaltelement 22 und ein zweites Schaltelement 48 auf. Das erste Schaltelement 22 ist zwischen dem ersten Heizanschluss 14 der Heizanschlüsse 14, 16 und dem ersten Versorgungsanschluss 18 der Versorgungsanschlüsse 18, 20 geschaltet. Ein erster Anschluss des ersten Schaltelements 22 und der erste Versorgungsanschluss 18 sind elektrisch miteinander verbunden. Ein zweiter Anschluss des ersten Schaltelements 22 und der erste Heizanschluss 14 sind elektrisch miteinander verbunden.

Das zweite Schaltelement 48 ist zwischen dem zweiten Heizanschluss 16 und dem zweiten Versorgungsanschluss 20 geschaltet. Ein erster Anschluss des zweiten Schaltelements 48 und der zweite Heizanschluss 16 sind elektrisch miteinander verbunden. Ein zweiter Anschluss des zweiten Schaltelements 48 und der zweite Versorgungsanschluss 20 sind elektrisch miteinander verbunden. Das zweite Schaltelement 48 stellt einen Hauptschalter des Hausgeräts 34 dar. Jedes Schaltelement 22, 48 weist ein Relais auf. Alternativ könnte zumindest eines der Schaltelemente beispielsweise einen Leistungshalbleiterschalter aufweisen.

Die Hausgeräteheizvorrichtung 10 weist eine Messeinheit 24 auf, die einen Messeingang 26 aufweist. An dem Messeingang 26 liegt wenigstens in einem Heizbetriebszustand ein Potential an. Der Messeingang 26 und der zweite Heizanschluss 16 sind elektrisch miteinander verbunden. Der Messeingang 26 und der erste Anschluss des zweiten Schaltelements 48 sind elektrisch miteinander verbunden. Der Messeingang 26 zweigt an einer Anschlussstelle 50 von der elektrischen Verbindung zwischen dem zweiten Heizanschluss 16 und dem ersten Anschluss des zweiten Schaltelements 48 ab. Zwischen dem Messeingang 26 und der Anschlussstelle 50 ist ein elektrischer Widerstand 52 geschaltet. Der Widerstand 52 weist einen Widerstandswert von im Wesentlichen 10 kΩ auf.

Die Messeinheit 24 weist einen Messausgang 54 auf. Ein erster Anschluss der Steuereinheit 28 und der Messausgang 54 sind elektrisch miteinander verbunden. Die Messeinheit 24 gibt über den Messausgang 54 einen Scheitelwert eines an dem Messeingang 26 anliegenden Potentials aus. Die Messeinheit 24 weist einen Gleichrichter 56 auf. Der Gleichrichter 56 weist einen Gleichrichtereingang auf, der elektrisch mit dem Messeingang 26 verbunden ist. Von einer elektrischen Verbindung zwischen dem Messeingang 26 und dem Gleichrichter 56 zweigt ein Messkondensator 58 ab. Der Messkondensator 58 weist eine Kapazität von im Wesentlichen 100 nF auf. Die Messeinheit 24 weist den Messkondensator 58 auf, der zu einem Ausfiltern eines Hochfrequenzanteils vorgesehen ist. Ein erster Anschluss des ersten Messkondensators 58 ist elektrisch mit der Verbindung zwischen dem Messeingang 26 und dem Gleichrichter 56 verbunden. Ein zweiter Anschluss des ersten Messkondensators 58 ist elektrisch mit Masse verbunden. Der Gleichrichter 56 ist von einem Operationsverstärker mit nachgeschalteter Diode gebildet. Alternativ könnte der Gleichrichter 56 von einem Brückengleichrichter gebildet sein.

Die Messeinheit 24 weist einen weiteren Messkondensator 60 auf, der zu einem Glätten einer von dem Gleichrichter 56 ausgegebenen Spannung vorgesehen ist. Der Messkondensator 60 weist eine Kapazität von im Wesentlichen 10 nF auf. Der weitere Messkondensator 60 zweigt an einer Messanschlussstelle 62 von einer Verbindung zwischen dem Gleichrichter 56 und dem Messausgang 54 ab. Ein erster Anschluss des weiteren Messkondensators 60 und die Messanschlussstelle 62 sind elektrisch miteinander verbunden. Der Gleichrichter 56 weist einen weiteren Gleichrichtereingang auf, der elektrisch mit der Messanschlussstelle 62 verbunden ist. Ein zweiter Anschluss des weiteren Messkondensators 60 ist elektrisch mit Masse verbunden.

Liegt an dem Messeingang 26 ein Potential an, wie dies beispielsweise in dem Heizbetriebszustand der Fall ist, wird der weitere Messkondensator 60 über den Gleichrichter 56 aufgeladen. Da der erste Anschluss des weiteren Messkondensators 60 über die Messanschlussstelle 62 mit dem weiteren Gleichrichtereingang verbunden ist, wird der weiteren Messkondensator 60 bis zu einem Spannungswert aufgeladen, der einem Wert der an dem Messeingang 26 anliegenden Potential entspricht. Dieser Wert wird anschließend über den Messausgang 54 an die Steuereinheit 28 ausgegeben. Hierdurch kann in einem Verfahren zu einem Betrieb der Hausgeräteheizvorrichtung 10 von der Steuereinheit 28 in dem Heizbetriebszustand ein an dem Messeingang 26 anliegendes Potential ermittelt werden. Das an dem Messeingang 26 anliegende Potential ist in dem Heizbetriebszustand variabel und ändert sich in Abhängigkeit einer Funktion des Heizelements 12.

Zu einer Überwachung einer Funktion des Heizelements 12 in dem Heizbetriebszustand weist die Hausgeräteheizvorrichtung 10 ein Sensorelement 30 auf (vgl. Fig. 2). Das Sensorelement 30 ist in dem Heizbetriebszustand zu einer Detektion eines Leckstroms aus dem Heizelement 12 ausgelegt. Ein aus dem Heizelement 12 austretender Leckstrom ist unerwünscht, wenngleich dieser bei Beheizung des Heizelements 12 immer auftritt. Der aus dem Heizelement 12 austretende Leckstrom ist bei Temperaturen unterhalb eines Schwellwerts vernachlässigbar klein. Bei Temperaturen oberhalb des Schwellwerts nimmt der Leckstrom stark zu und deutet auf eine Fehlfunktion des Heizelements 12 hin. Das Sensorelement 30 und der Messeingang 26 sind elektrisch miteinander verbunden. Eine elektrische Verbindung zwischen dem Sensorelement 30 sowie dem Messeingang 26 und eine elektrische Verbindung zwischen der Anschlussstelle 50 sowie dem Messeingang 26 weisen eine gemeinsame Kontaktstelle 64 auf.

Wenigstens in dem Heizbetriebszustand führen zwei parallele Leitungspfade 66, 68 von einem der Versorgungsanschlüsse 18, 20 zu dem Messeingang 26. Ein erster Leitungspfad 66 der Leitungspfade 66, 68 führt von einem der Versorgungsanschlüsse 18, 20 über das Heizelement 12 und das Sensorelement 30 zu dem Messeingang 26. Der erste Leitungspfad 66 der Leitungspfade 66, 68 weist einen Bereich zwischen dem Heizelement 12 und dem Sensorelement 30 auf, durch den der Leckstrom fließt. Ein zweiter Leitungspfad 68 der Leitungspfade 66, 68 führt von einem der Versorgungsanschlüsse 18, 20 über die Anschlussstelle 50 und den elektrischen Widerstand 52 zu dem Messeingang 26. Der sich in dem zweiten Leitungspfad 68 befindliche elektrische Widerstand 52 ist zwischen der Anschlussstelle 50 und der Kontaktstelle 64 geschaltet.

Zwischen dem Sensorelement 30 und der Kontaktstelle 64 sind eine Kapazität und ein ohmscher Widerstand, und zwar insbesondere ein Kondensator 70, ein erster Widerstand 72 und ein zweiter Widerstand 74, in Reihe geschaltet. Der Kondensator 70 weist eine Kapazität von im Wesentlichen 100 nF auf. Der erste Widerstand 72 weist einen Widerstandswert in einem Bereich von 30 kΩ bis 50 kΩ, insbesondere von im Wesentlichen 33 kΩ, auf. Der zweite Widerstand 74 weist einen Widerstandswert in einem Bereich von 30 kΩ bis 50 kΩ, insbesondere von im Wesentlichen 33 kΩ, auf. Das Sensorelement 30 und ein erster Anschluss des Kondensators 70 sind elektrisch miteinander verbunden. Von der Verbindung zwischen dem Sensorelement 30 und dem ersten Anschluss des Kondensators 70 zweigt ein Kondensator 76 ab. Ein erster Anschluss des Kondensators 76 und die Verbindung zwischen dem Sensorelement 30 und dem ersten Anschluss des Kondensators 70 sind elektrisch miteinander verbunden. Ein zweiter Anschluss des Kondensators 76 ist elektrisch mit Erde verbunden. Die Reihenschaltung aus dem Kondensator 70, dem ersten Widerstand 72 und dem zweiten Widerstand 74 weist einen spezifischen Widerstand mit einem Wert auf, der im Wesentlichen zehn Mal so groß ist wie ein Wert des sich in dem zweiten Leitungspfad 68 befindlichen elektrischen Widerstands 52.

Falls eines der Schaltelemente 22, 48 geschlossen und ein weiteres der Schaltelemente 22, 48 geöffnet ist, liegt an dem Messeingang 26 ein Potential mit einem Wert an, der von einer an dem Heizelement 12 anliegenden Netzform abhängig ist. Je nach Land, in welchem das Hausgerät 34 verwendet wird, liegen unterschiedliche Netzformen an dem Heizelement 12 an. Da sich das an dem Messeingang 26 anliegende Potential abhängig von einer an dem Heizelement 12 anliegenden Netzform ändert, sollte zu einer exakten Detektion des aus dem Heizelement 12 in dem Heizbetriebszustand austretenden Leckstroms die an dem Heizelement 12 anliegende Netzform bekannt sein.

Nachfolgende unvollständige Tabelle gibt einige Beispiele an Netzformen für verschiedene Länder an:

| Land | Dreiphasenwechselstrom | Einphasenwechselstrom |
|---|---|---|
| Deutschland | 400 V | 230 V |
| Schweiz | 400 V | 230 V |
| Großbritannien | 415 V | 240 V |
| Australien | 415 V | 240 V |
| Japan | 200 V | 100 V |
| Philippinen | 380 V | 220 V |

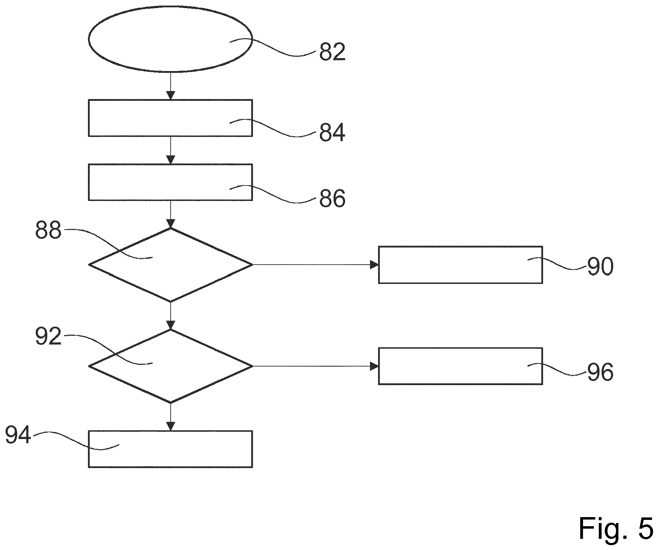

In einem Verfahren zu einem Betrieb der Hausgeräteheizvorrichtung 10 wird, insbesondere bei einer erstmaligen Aktivierung des Hausgeräts 34, in einem ersten Verfahrensschritt 82 ein Netzformerkennungsbetriebszustand gestartet (vgl. Fig. 5). Die Steuereinheit 28 startet den Netzformerkennungsbetriebszustand automatisch. In dem Netzformerkennungsbetriebszustand unterbricht die Steuereinheit 28 in einem ersten Messschritt 84 einen Leitungspfad durch das Heizelement 12 mittels des ersten Schaltelements 22 bei geschlossenem zweitem Schaltelement 48. In dem ersten Messschritt 84 liegt ein erstes Potential an dem Messeingang 26 an. Die Steuereinheit 28 berücksichtigt in dem Netzformerkennungsbetriebszustand das an dem Messeingang 26 anliegende erste Potential bei einer Ermittlung einer an dem Heizelement 12 anliegenden Netzform. Die Steuereinheit 28 speichert das erste Potential in dem Netzformerkennungsbetriebszustand in einer Speichereinheit der Steuereinheit 28.

In einem zweiten Messschritt 86 unterbricht die Steuereinheit 28 in dem Netzformerkennungsbetriebszustand einen Leitungspfad durch das Heizelement 12 mittels des zweiten Schaltelements 48 bei geschlossenem ersten Schaltelement 22. In dem zweiten Messschritt 86 liegt ein zweites Potential an dem Messeingang 26 an. Die Steuereinheit 28 berücksichtigt in dem Netzformerkennungsbetriebszustand das an dem Messeingang 26 anliegende zweite Potential bei einer Ermittlung einer an dem Heizelement 12 anliegenden Netzform. Die Steuereinheit 28 speichert das zweite Potential in dem Netzformerkennungsbetriebszustand in der Speichereinheit der Steuereinheit 28.

In dem Netzformerkennungsbetriebszustand ermittelt die Steuereinheit 28 in einem ersten Prüfungsschritt 88 einen Betrag einer Differenz aus dem ersten Potential und dem zweiten Potential. Die Steuereinheit 28 vergleicht in dem Netzformerkennungsbetriebszustand den Betrag der Differenz aus dem ersten Potential und dem zweiten Potential mit einem in der Speichereinheit der Steuereinheit 28 gespeicherten Differenz-Referenzpotential. Das Differenz-Referenzpotential beträgt im vorliegenden Ausführungsbeispiel im Wesentlichen 30 mV.

In dem Fall, dass der Betrag der Differenz aus dem ersten Potential und dem zweiten Potential größer ist als das in der Speichereinheit der Steuereinheit gespeicherte Differenz-Referenzpotential, schließt die Steuereinheit 28 in dem Netzformerkennungsbetriebszustand auf ein Anliegen eines Nullleiters an einem der Versorgungsanschlüsse 18, 20. In dem Netzformerkennungsbetriebszustand erkennt die Steuereinheit 28 anhand der an dem Messeingang 26 anliegenden Potentiale ein Anliegen eines Nullleiters an einem der Versorgungsanschlüsse 18, 20. Im Fall eines Anliegens eines Nullleiters an einem der Versorgungsanschlüsse 18, 20 unterscheiden sich das erste Potential und das zweite Potential wesentlich voneinander.

Je nach Steckrichtung eines Gerätesteckers in einer Anschlussdose des Versorgungsnetzes sind Nullleiter und Phasenleiter vertauscht. Da sich das an dem Messeingang 26 anliegende Potential abhängig von einer an dem Heizelement 12 anliegenden Polung ändert, sollte zu einer exakten Detektion des aus dem Heizelement 12 in dem Heizbetriebszustand austretenden Leckstroms eine eindeutige Polung sichergestellt werden.

Die Steuereinheit 28 startet in dem Fall, dass die Steuereinheit 28 ein Anliegen eines Nullleiters an einem der Versorgungsanschlüsse 18, 20 erkennt, in einem Polungsdetektionsschritt 90 einen Polungsdetektionsbetriebszustand. In dem Polungsdetektionsbetriebszustand ermittelt die Steuereinheit 28 den Versorgungsabschluss 18, 20, an welchem der Nullleiter anliegt.

Die Steuereinheit 28 vergleicht in dem Polungsdetektionsbetriebszustand das erste Potential mit einem in der Speichereinheit der Steuereinheit 28 gespeicherten unteren Referenzpotential. In dem Polungsdetektionsbetriebszustand erkennt die Steuereinheit 28 in dem Fall, dass das erste Potential kleiner ist als das untere Referenzpotential, ein Anliegen eines Nullleiters an dem ersten Heizanschluss 14. Die Steuereinheit 28 erkennt in dem Polungsdetektionsbetriebszustand in dem Fall, dass das erste Potential kleiner ist als das untere Referenzpotential, ein Anliegen eines Phasenleiters an dem zweiten Heizanschluss 16. Das untere Referenzpotential beträgt im vorliegenden Ausführungsbeispiel im Wesentlichen 30 mV.

In dem Netzformerkennungsbetriebszustand ermittelt die Steuereinheit 28 in dem Polungsdetektionsschritt 90 anhand der ermittelten Netzform einen Abschaltgrenzwert für das Heizelement 12. Die Steuereinheit 28 entnimmt der Speichereinheit der Steuereinheit 28 in dem Netzformerkennungsbetriebszustand einen der ermittelten Netzform zugeordneten Abschaltgrenzwert. Im Fall eines Anliegens eines Nullleiters an dem ersten Heizanschluss 14 beträgt der ermittelte Abschaltgrenzwert für das Heizelement 12 im vorliegenden Ausführungsbeispiel im Wesentlichen 600 mV.

Die Steuereinheit 28 vergleicht in dem Polungsdetektionsbetriebszustand das erste Potential mit einem in der Speichereinheit der Steuereinheit 28 gespeicherten oberen Referenzpotential. In dem Polungsdetektionsbetriebszustand erkennt die Steuereinheit 28 in dem Fall, dass das erste Potential größer ist als das obere Referenzpotential, ein Anliegen eines Phasenleiters an dem ersten Heizanschluss 14. Die Steuereinheit 28 erkennt in dem Polungsdetektionsbetriebszustand in dem Fall, dass das erste Potential größer ist als das obere Referenzpotential, ein Anliegen eines Nullleiters an dem zweiten Heizanschluss 16. Das obere Referenzpotential beträgt im vorliegenden Ausführungsbeispiel im Wesentlichen 500 mV.

In dem Netzformerkennungsbetriebszustand ermittelt die Steuereinheit 28 in dem Polungsdetektionsschritt 90 anhand der ermittelten Netzform einen Abschaltgrenzwert für das Heizelement 12. Die Steuereinheit 28 entnimmt der Speichereinheit der Steuereinheit 28 in dem Netzformerkennungsbetriebszustand einen der ermittelten Netzform zugeordneten Abschaltgrenzwert. Im Fall eines Anliegens eines Nullleiters an dem zweiten Heizanschluss 16 beträgt der ermittelte Abschaltgrenzwert für das Heizelement 12 im vorliegenden Ausführungsbeispiel im Wesentlichen 1200 mV.

In dem Fall, dass der Betrag der Differenz aus dem ersten Potential und dem zweiten Potential kleiner ist als das in der Speichereinheit der Steuereinheit 28 gespeicherte Differenz-Referenzpotential, schließt die Steuereinheit 28 auf eine Abwesenheit eines Nullleiters an den Versorgungsanschlüssen 18, 20.

Die Steuereinheit 28 prüft in dem Fall, dass der Betrag der Differenz aus dem ersten Potential und dem zweiten Potential kleiner ist als das in der Speichereinheit der Steuereinheit 28 gespeicherte Differenz-Referenzpotential, in einem zweiten Prüfungsschritt 92 in dem Netzformerkennungsbetriebszustand das erste Potential und das zweite Potential auf deren Gültigkeit. In dem Netzformerkennungsbetriebszustand vergleicht die Steuereinheit 28 das erste Potential und das zweite Potential jeweils mit einem in der Speichereinheit der Steuereinheit 28 gespeicherten Gültigkeitsbereich.

In dem Fall, dass das erste Potential und das zweite Potential jeweils innerhalb des Gültigkeitsbereichs liegen, erkennt die Steuereinheit 28 in dem Netzformerkennungsbetriebszustand in einem Folgerungsschritt 94 anhand der an dem Messeingang 26 anliegenden Potentiale ein Anliegen von Phasenleitern an den Versorgungsanschlüssen 18, 20. Im vorliegenden Ausführungsbeispiel ist der Gültigkeitsbereich im Wesentlichen von 300 mV bis 420 mV. Der Gültigkeitsbereich ist für das Anliegen von Phasenleitern an den Versorgungsanschlüssen 18, 20 relevant. Für das Anliegen eines Nullleiters an einem der Versorgungsanschlüsse 18, 20 ist der Gültigkeitsbereich irrelevant. Im Fall eines Anliegens von Phasenleitern an den Versorgungsanschlüssen 18, 20 unterscheiden sich das erste Potential und das zweite Potential nur geringfügig voneinander.

In dem Netzformerkennungsbetriebszustand ermittelt die Steuereinheit 28 in dem Folgerungsschritt 94 anhand der ermittelten Netzform einen Abschaltgrenzwert für das Heizelement 12. Die Steuereinheit 28 entnimmt der Speichereinheit der Steuereinheit 28 in dem Netzformerkennungsbetriebszustand einen der ermittelten Netzform zugeordneten Abschaltgrenzwert. Im Fall eines Anliegens von Phasenleitern an den Versorgungsanschlüssen 18, 20 beträgt der ermittelte Abschaltgrenzwert für das Heizelement 12 im vorliegenden Ausführungsbeispiel im Wesentlichen 900 mV.

In dem Fall, dass zumindest eines der Potentiale außerhalb des Gültigkeitsbereichs liegt, verzichtet die Steuereinheit 28 in dem Netzformerkennungsbetriebszustand auf eine Verwendung der Potentiale bei der Erkennung eines Anliegens von Phasenleitern an den Versorgungsanschlüssen 18, 20. Die Steuereinheit 28 erkennt in dem Netzformerkennungsbetriebszustand in dem Fall, dass zumindest eines der Potentiale außerhalb des Gültigkeitsbereichs liegt, in einem Fehlererkennungsschritt 96 anhand der an dem Messeingang anliegenden Potentiale einen Gerätedefekt.

In dem Fall, dass zumindest eines der Potentiale außerhalb des Gültigkeitsbereichs liegt, gibt die Steuereinheit 28 in dem Fehlererkennungsschritt 96 über die Anzeigeeinheit der Bedieneinheit 46 eine Warnung insbesondere an einen Bediener aus. In diesem Fall erkennt die Steuereinheit 28 einen vorliegenden Hardwarefehler, welcher beispielsweise von dem Heizelement 12 und/oder von einem der Schaltelemente 22, 48 verursacht sein könnte, und/oder auf einen vorliegenden Softwarefehler.

Das Heizelement 12 und das Sensorelement 30 bilden gemeinsam einen Kondensator aus (vgl. Fig. 2). Das Sensorelement 30 und das Heizelement 12 sind in einem montierten Zustand benachbart angeordnet. Das Heizelement 12 und das Sensorelement 30 sind jeweils als Schicht ausgebildet. Die Hausgeräteheizvorrichtung 10 weist ein Basiselement 78 auf, auf welchem das Heizelement 12 und das Sensorelement 30 in dem montierten Zustand aufgebracht sind. Das Basiselement 78 ist geerdet (vgl. Fig. 3).

Die Hausgeräteheizvorrichtung 10 weist ein Dielektrikum 32 auf, das zwischen dem Heizelement 12 und dem Sensorelement 30 angeordnet ist (vgl. Fig. 2). Das Dielektrikum 32 weist einen temperaturabhängigen spezifischen Widerstand auf. Unterhalb eines Schwellwerts ändert sich der temperaturabhängige spezifische Widerstand des Dielektrikums 32 nur geringfügig. Das Dielektrikum 32 blockiert bei Temperaturen des Heizelements 12 unterhalb des Schwellwerts, wie beispielsweise in dem Netzformerkennungsbetriebszustand und/oder in dem Polungsdetektionsbetriebszustand, zumindest im Wesentlichen einen Stromfluss zwischen dem Heizelement 12 und dem Sensorelement 30. Der temperaturabhängige spezifische Widerstand des Dielektrikums 32 nimmt bei Temperaturen oberhalb des Schwellwerts mit steigender Temperatur ab. Ein Betrag des Schwellwerts ist in einem Bereich einer beginnenden Überhitzung des Heizelements 12 gewählt. Im vorliegenden Ausführungsbeispiel beträgt der Schwellwert im Wesentlichen 300°C.

Das Sensorelement 30 und das Basiselement 78 bilden gemeinsam einen Kondensator aus. Die Hausgeräteheizvorrichtung 10 weist ein weiteres Dielektrikum 80 auf, das zwischen dem Sensorelement 30 und dem Basiselement 78 angeordnet ist. Das weitere Dielektrikum 80 weist einen im Wesentlichen temperaturunabhängigen spezifischen Widerstand auf, der sich bei steigender Temperatur nur unwesentlich ändert. Unabhängig von einem Betriebszustand blockiert das weitere Dielektrikum 80 zumindest im Wesentlichen einen Stromfluss zwischen dem Sensorelement 30 und dem Basiselement 78.

Gibt ein Bediener mittels der Bedieneinheit 46 eine Heizleistung für das Heizelement 12 vor, startet die Steuereinheit 28 den Heizbetriebszustand. Zu einem Starten des Heizbetriebszustands schließt die Steuereinheit 28 das Schaltelement 22 sowie das zweite Schaltelement 48 (vgl. Fig. 4). Bei Temperaturen des Heizelements 12 unterhalb des Schwellwerts verhindert das Dielektrikum 32 mittels des spezifischen Widerstands des Dielektrikums 32 zumindest im Wesentlichen einen aus dem Heizelement 12 austretenden Leckstrom.

Nimmt das Heizelement 12 Temperaturen oberhalb des Schwellwerts an, tritt aus dem Heizelement 12 ein wesentlich von Null verschiedener Leckstrom aus. Der aus dem Heizelement 12 austretende Leckstrom nimmt in Abhängigkeit von einer Temperatur des Heizelements 12 unterschiedliche Werte an. Der aus dem Heizelement 12 austretende Leckstrom nimmt für höhere Temperaturen des Heizelements 12 höhere Werte an.

In dem Heizbetriebszustand ermittelt die Steuereinheit 28 eine von dem Leckstrom des Heizelements 12 abhängige Kenngröße. Die Kenngröße weist eine Temperatur des Heizelements 12 auf. Die Steuereinheit 28 prüft in dem Heizbetriebszustand anhand der Kenngröße, ob eine Überhitzung des Heizelements 12 vorliegt. In dem Heizbetriebszustand nutzt die Steuereinheit 28 den temperaturabhängigen spezifischen Widerstand des Dielektrikums 32 zu einer Ermittlung der Kenngröße aus. In der Speichereinheit der Steuereinheit 28 ist ein zu erwartender Wert des Leckstroms in Abhängigkeit von einer Temperatur des Heizelements 12 gespeichert. Die Steuereinheit 28 vergleicht in dem Heizbetriebszustand den ermittelten Wert des Leckstroms, den die Steuereinheit 28 aus dem an dem Messeingang 26 anliegenden Potential ermittelt, mit den in der Speichereinheit gespeicherten Werten des Leckstroms. Hieraus ermittelt die Steuereinheit 28 in dem Heizbetriebszustand die Kenngröße.

Bei einer Ermittlung der von dem Leckstrom des Heizelements 12 abhängigen Kenngröße berücksichtigt die Steuereinheit 28 in dem Heizbetriebszustand die an dem Heizelement 12 anliegende Netzform. In dem Heizbetriebszustand wählt die Steuereinheit 28 abhängig von einer an dem Heizelement 12 anliegenden Netzformunterschiedliche in der Speichereinheit der Steuereinheit 28 gespeicherte Abschaltgrenzwerte zu einem Vergleich mit dem von der Messeinheit 24 an die Steuereinheit 28 übermittelten Wert des an dem Messeingang 26 anliegenden Potentials.

Nimmt der aus dem Heizelement 12 austretende Leckstrom einen Wert oberhalb des in der Speichereinheit gespeicherten und von der Steuereinheit 28 ermittelten Abschaltgrenzwerts an, deaktiviert die Steuereinheit 28 in dem Heizbetriebszustand das Heizelement 12, insbesondere durch Öffnen des Schaltelements 22 und/oder des zweiten Schaltelements 48. Alternativ oder zusätzlich gibt die Steuereinheit 28 in dem Heizbetriebszustand eine Warnung insbesondere an einen Bediener aus, sollte der aus dem Heizelement 12 austretende Leckstrom einen Wert oberhalb des in der Speichereinheit gespeicherten und von der Steuereinheit 28 ermittelten Abschaltgrenzwerts annehmen.

In dem Heizbetriebszustand hängt ein Wert des an dem Messeingang 26 anliegenden Potentials von einer beheizten Fläche des Heizelements 12 ab. Das an dem Messeingang 26 anliegende Potential nimmt in dem Heizbetriebszustand in Abhängigkeit von einer Anzahl aktivierter Heizkreise des Heizelements 12 unterschiedliche Werte an. Die Steuereinheit 28 erkennt in dem Heizbetriebszustand mittels des an dem Messeingang 26 anliegenden Potentials eine Anzahl aktivierter Heizkreise des Heizelements 12. In dem Heizbetriebszustand erkennt die Steuereinheit 28 anhand des an dem Messeingang 26 anliegenden Potentials defekte Heizkreise des Heizelements 12. Im Fall von einem und/oder mehreren defekten Heizkreisen des Heizelements 12 gibt die Steuereinheit 28 in dem Heizbetriebszustand mittels der Anzeigeeinheit eine Warnung insbesondere an einen Bediener aus und/oder deaktiviert das Heizelement 12, insbesondere durch Öffnen des ersten Schaltelements 22 und/oder des zweiten Schaltelements 48.

Wird das Heizelement 12 zu einer Erhitzung von Wasser verwendet, können sich Kalkrückstände auf dem Heizelement 12 ablagern. Kalkrückstände auf dem Heizelement 12 haben eine isolierende Wirkung und verringern in dem Heizbetriebszustand einen maximalen Wärmeübergang von dem Heizelement 12 zu von dem Heizelement 12 zu erhitzendem Gargut, wie beispielsweise Wasser. In dem Heizbetriebszustand haben Kalkrückstände auf dem Heizelement 12 eine Erhöhung der Temperatur des Heizelements 12 zur Folge. Im Extremfall könnte das Heizelement 12 überhitzen und insbesondere durch Kalkrückstände auf dem Heizelement 12 zerstört werden.

In dem Heizbetriebszustand hängt ein Wert des an dem Messeingang 26 anliegenden Potentials von einer Größe einer Verschmutzung des Heizelements 12 ab. Die Verschmutzung könnte beispielsweise als Verkalkung ausgebildet sein. Das an dem Messeingang 26 anliegende Potential nimmt in dem Heizbetriebszustand in Abhängigkeit von einer Größe einer Verschmutzung des Heizelements 12 unterschiedliche Werte an. Die Steuereinheit 28 erkennt in dem Heizbetriebszustand mittels des an dem Messeingang 26 anliegenden Potentials eine vorliegende Verschmutzung des Heizelements 12. In dem Heizbetriebszustand gibt die Steuereinheit 28 mittels der Anzeigeeinheit eine Information insbesondere an einen Bediener über eine vorliegende Verschmutzung des Heizelements 12 aus. Alternativ oder zusätzlich deaktiviert die Steuereinheit 28 in dem Heizbetriebszustand das Heizelement 12, insbesondere durch Öffnen des ersten Schaltelements 22 und/oder des zweiten Schaltelements 48.

Hierdurch kann insbesondere ein Notbetrieb des Heizelements 12 erreicht werden, insbesondere im Fall von einem und/oder mehreren defekten Heizkreisen des Heizelements 12 und/oder im Fall einer vorliegenden Verschmutzung des Heizelements 12. Darüber hinaus können im Fall einer Überhitzung des Heizelements 12 Maßnahmen zu einem Schutz vor einer Überhitzung des Heizelements 12 getroffen werden, insbesondere durch von der Steuereinheit 28 ausgeführte Aktionen.

Alternativ könnte beispielsweise auf das Basiselement verzichtet werden. Ebenfalls denkbar sind Ausgestaltungen mit unterschiedlichen Anzahlen an Heizelementen und/oder Sensorelementen.

### Bezugszeichen

- 10: Hausgeräteheizvorrichtung
- 12: Heizelement
- 14: Erster Heizanschluss
- 16: Zweiter Heizanschluss
- 18: Erster Versorgungsanschluss
- 20: Zweiter Versorgungsanschluss
- 22: Schaltelement
- 24: Messeinheit
- 26: Messeingang
- 28: Steuereinheit
- 30: Sensorelement
- 32: Dielektrikum
- 34: Hausgerät
- 36: Gehäuse
- 38: Gerätetür
- 40: Garraum
- 42: Muffel
- 44: Gebläse
- 46: Bedieneinheit
- 48: Weiteres Schaltelement
- 50: Anschlussstelle
- 52: Widerstand
- 54: Messausgang
- 56: Gleichrichter
- 58: Messkondensator
- 60: Weiterer Messkondensator
- 62: Messanschlussstelle
- 64: Kontaktstelle
- 66: Erster Leitungspfad
- 68: Zweiter Leitungspfad
- 70: Kondensator
- 72: Erster Widerstand
- 74: Zweiter Widerstand
- 76: Kondensator
- 78: Basiselement
- 80: Weiteres Dielektrikum
- 82: Erster Verfahrensschritt
- 84: Erster Messschritt
- 86: Zweiter Messschritt
- 88: Erster Prüfungsschritt
- 90: Polungsdetektionsschritt
- 92: Zweiter Prüfungsschritt
- 94: Folgerungsschritt
- 96: Fehlererkennungsschritt

## Patentansprüche

1. Hausgeräteheizvorrichtung mit zumindest einem Heizelement (12), das zumindest zwei Heizanschlüsse (14, 16) aufweist, die jeweils zu einem Anschluss an einen von zumindest zwei Versorgungsanschlüssen (18, 20) eines Versorgungsnetzes vorgesehen sind, mit zumindest einem ersten Schaltelement (22), das zwischen einem ersten Heizanschluss (14) der Heizanschlüsse (14, 16) und einem ersten Versorgungsanschluss (18) der Versorgungsanschlüsse (18, 20) geschaltet ist, mit zumindest einem zweiten Schaltelement (48), das zwischen einem zweiten Heizanschluss (16) der Heizanschlüsse (14, 16) und einem zweiten Versorgungsanschluss (20) der Versorgungsanschlüsse (18, 20) geschaltet ist, und mit einer Messeinheit (24), die zumindest einen Messeingang (26) aufweist, an dem in wenigstens einem Heizbetriebszustand ein Potential anliegt, **gekennzeichnet durch** eine Steuereinheit (28), die dazu ausgelegt ist, in wenigstens einem Netzformerkennungsbetriebszustand einen Leitungspfad durch das Heizelement (12) mittels des ersten Schaltelements (22) bei geschlossenem zweitem Schaltelement (48) zu unterbrechen und ein an dem Messeingang (26) anliegendes erstes Potential bei einer Ermittlung einer an dem Heizelement (12) anliegenden Netzform zu berücksichtigen, wobei die Steuereinheit (28) dazu ausgelegt ist, in dem wenigstens einen Netzformerkennungsbetriebszustand einen Leitungspfad durch das Heizelement (12) mittels des zweiten Schaltelements (48) bei geschlossenem ersten Schaltelement (22) zu unterbrechen und ein an dem Messeingang (26) anliegendes zweites Potential bei der Ermittlung der an dem Heizelement (12) anliegenden Netzform zu berücksichtigen, wobei die Steuereinheit (28) dazu ausgelegt ist, in dem wenigstens einen Netzformerkennungsbetriebszustand das erste und das zweite Potential miteinander zu vergleichen und eine Differenz aus dem ersten und dem zweiten Potential zu berechnen.

2. Hausgeräteheizvorrichtung nach Anspruch 1, **dadurch gekennzeichnet, dass** die Steuereinheit (28) dazu ausgelegt ist, in dem Netzformerkennungsbetriebszustand anhand der an dem Messeingang (26) anliegenden Potentiale ein Anliegen eines Nullleiters an einem der Versorgungsanschlüsse (18, 20) zu erkennen.

3. Hausgeräteheizvorrichtung nach Anspruch 2, **dadurch gekennzeichnet, dass** die Steuereinheit (28) dazu ausgelegt ist, in wenigstens einem Polungsdetektionsbetriebszustand den Versorgungsanschluss (18, 20), an welchem der Nullleiter anliegt, zu ermitteln.

4. Hausgeräteheizvorrichtung nach einem der vorhergehenden Ansprüche, **dadurch gekennzeichnet, dass** die Steuereinheit (28) dazu ausgelegt ist, in dem Netzformerkennungsbetriebszustand anhand der an dem Messeingang (26) anliegenden Potentiale ein Anliegen von Phasenleitern an den Versorgungsanschlüssen (18, 20) zu erkennen.

5. Hausgeräteheizvorrichtung nach einem der vorhergehenden Ansprüche, **dadurch gekennzeichnet, dass** die Steuereinheit (28) dazu ausgelegt ist, in dem Netzformerkennungsbetriebszustand anhand der an dem Messeingang (26) anliegenden Potentiale zumindest einen Gerätedefekt zu erkennen.

6. Hausgeräteheizvorrichtung nach einem der vorhergehenden Ansprüche, **dadurch gekennzeichnet, dass** die Steuereinheit (28) dazu ausgelegt ist, in dem Netzformerkennungsbetriebszustand anhand der ermittelten Netzform einen Abschaltgrenzwert für das Heizelement (12) zu ermitteln.

7. Hausgeräteheizvorrichtung nach einem der vorhergehenden Ansprüche, **gekennzeichnet durch** zumindest ein Sensorelement (30), das in dem Heizbetriebszustand zu einer Detektion eines Leckstroms aus dem Heizelement (12) ausgelegt ist.

8. Hausgeräteheizvorrichtung nach Anspruch 7, **dadurch gekennzeichnet, dass** die Steuereinheit (28) dazu ausgelegt ist, in dem Heizbetriebszustand zumindest eine von dem Leckstrom des Heizelements (12) abhängige Kenngröße zu ermitteln.

9. Hausgeräteheizvorrichtung nach Anspruch 8, **dadurch gekennzeichnet, dass** die Steuereinheit (28) dazu ausgelegt ist, in dem Heizbetriebszustand die an dem Heizelement (12) anliegende Netzform bei einer Ermittlung der von dem Leckstrom des Heizelements (12) abhängigen Kenngrößen zu berücksichtigen.

10. Hausgerät mit zumindest einer Hausgeräteheizvorrichtung nach einem der vorhergehenden Ansprüche.

11. Verfahren zu einem Betrieb einer Hausgeräteheizvorrichtung mit zumindest einem Heizelement (12), das zumindest zwei Heizanschlüsse (14, 16) aufweist, die jeweils zu einem Anschluss an einen von zumindest zwei Versorgungsanschlüssen (18, 20) eines Versorgungsnetzes vorgesehen sind, mit zumindest einem ersten Schaltelement (22), das zwischen einem ersten Heizanschluss (14) der Heizanschlüsse (14, 16) und einem ersten Versorgungsanschluss (18) der Versorgungsanschlüsse (18, 20) geschaltet ist, mit zumindest einem zweiten Schaltelement (48), das zwischen einem zweiten Heizanschluss (16) der Heizanschlüsse (14, 16) und einem zweiten Versorgungsanschluss (20) der Versorgungsanschlüsse (18, 20) geschaltet ist, und mit einer Messeinheit (24), die zumindest einen Messeingang (26) aufweist, an dem in wenigstens einem Heizbetriebszustand ein Potential anliegt, **dadurch gekennzeichnet, dass** in wenigstens einem Netzformerkennungsbetriebszustand ein Leitungspfad durch das Heizelement (12) mittels des ersten Schaltelements (22) bei geschlossenem zweiten Schaltelement (48) unterbrochen und ein an dem Messeingang (26) anliegendes erstes Potential bei einer Ermittlung einer an dem Heizelement (12) anliegenden Netzform berücksichtigt wird, wobei in dem wenigstens einen Netzformerkennungsbetriebszustand ein Leitungspfad durch das Heizelement (12) mittels des zweiten Schaltelements (48) bei geschlossenem ersten Schaltelement (22) unterbrochen wird und ein an dem Messeingang (26) anliegendes zweites Potential bei der Ermittlung der an dem Heizelement (12) anliegenden Netzform berücksichtigt wird, wobei in dem wenigstens einen Netzformerkennungsbetriebszustand das erste und das zweite Potential miteinander verglichen werden und eine Differenz aus dem ersten und dem zweiten Potential berechnet wird.

## Claims

1. Household appliance heating apparatus with at least one heating element (12), which has at least two heating connections (14, 16), which are each provided for connection to one of at least two supply connections (18, 20) of a supply network, with at least one first switching element (22), which is connected between a first heating connection (14) of the heating connections (14, 16) and a first supply connection (18) of the supply connections (18, 20), with at least one second switching element (48), which is connected between a second heating connection (16) of the heating connections (14, 16) and a second supply connection (20) of the supply connections (18, 20), and with a measuring unit (24), which has at least one measuring input (26), at which a potential is present in at least one heating operating state, **characterised by** a control unit (28), which is designed to interrupt a conduction path through the heating element (12) by means of the first switching element (22) with the second switching element (48) closed in at least one network form recognition operating state and to take into account a first potential present at the measuring input (26) when determining a network form present at the heating element (12), wherein the control unit (28) is designed to interrupt a conduction path through the heating element (12) by means of the second switching element (48) with the first switching element (22) closed in the at least one network form recognition operating state and to take into account a second potential present at the measuring input (26) when determining the network form present at the heating element (12), wherein the control unit (28) is designed to compare the first and the second potential with one another in the at least one network form recognition operating state and to calculate a difference between the first and the second potential.

2. Household appliance heating apparatus according to claim 1, **characterised in that** the control unit (28) is designed to recognise a presence of a zero conductor at one of the supply connections (18, 20) from the potentials present at the measuring input (26) in the network form recognition operating state.

3. Household appliance heating apparatus according to claim 2, **characterised in that** the control unit (28) is designed to determine the supply connection (18, 20) at which the zero conductor is present in at least one polarity detection operating state.

4. Household appliance heating apparatus according to one of the preceding claims, **characterised in that** the control unit (28) is designed to recognise a presence of phase conductors at the supply connections (18, 20) from the potentials present at the measuring input (26) in the network form recognition operating state.

5. Household appliance heating apparatus according to one of the preceding claims, **characterised in that** the control unit (28) is designed to recognise at least one appliance defect from the potentials present at the measuring input (26) in the network form recognition operating state.

6. Household appliance heating apparatus according to one of the preceding claims, **characterised in that** the control unit (28) is designed to determine a trip limit value for the heating element (12) from the determined network form in the network form recognition operating state.

7. Household appliance heating apparatus according to one of the preceding claims, **characterised by** at least one sensor element (30), which is designed to detect a leakage current from the heating element (12) in the heating operating state.

8. Household appliance heating apparatus according to claim 7, **characterised in that** the control unit (28) is designed to determine at least one characteristic variable that is a function of the leakage current from the heating element (12) in the heating operating state.

9. Household appliance heating apparatus according to claim 8, **characterised in that** the control unit (28) is designed to take into account the network form present at the heating element (12) when determining the characteristic variable that is a function of the leakage current from the heating element (12) in the heating operating state.

10. Household appliance with at least one household appliance heating apparatus according to one of the preceding claims.

11. Method for operating a household appliance heating apparatus with at least one heating element (12), which has at least two heating connections (14, 16), which are each provided for connection to one of at least two supply connections (18, 20) of a supply network, with at least one first switching element (22), which is connected between a first heating connection (14) of the heating connections (14, 16) and a first supply connection (18) of the supply connections (18, 20), with at least one second switching element (48), which is connected between a second heating connection (16) of the heating connections (14, 16) and a second supply connection (20) of the supply connections (18, 20), and with a measuring unit (24), which has at least one measuring input (26), at which a potential is present in at least one heating operating state, **characterised in that** a conduction path through the heating element (12) is interrupted by means of the first switching element (22) with the second switching element (48) closed in at least one network form recognition operating state and a first potential present at the measuring input (26) is taken into account when determining a network form present at the heating element (12), wherein a conduction path through the heating element (12) is interrupted by means of the second switching element (48) with the first switching element (22) closed in the at least one network form recognition operating state and a second potential present at the measuring input (26) is taken into account when determining the network form present at the heating element (12), wherein the first and the second potential are compared with one another in the at least one network form recognition operating state and a difference between the first and the second potential is calculated.

## Revendications

1. Dispositif chauffant pour appareil ménager comprenant au moins un élément chauffant (12), lequel présente au moins deux bornes de chauffage (14, 16), qui sont prévues à chaque fois pour un raccordement sur un d'au moins deux raccordements d'alimentation (18, 20) d'un réseau d'alimentation, avec au moins un premier élément de branchement (22), lequel est branché entre une première borne de chauffage (14) des bornes de chauffage (14, 16) et un premier raccordement d'alimentation (18) des raccordements d'alimentation (18, 20), avec au moins un deuxième élément de branchement (48), lequel est branché entre une deuxième borne de chauffage (16) des bornes de chauffage (14, 16) et un deuxième raccordement d'alimentation (20) des raccordements d'alimentation (18, 20), et avec une unité de mesure (24) qui présente au moins une entrée de mesure (26), à laquelle est appliqué un potentiel, dans au moins un état de fonctionnement du chauffage, **caractérisé par** une unité de commande (28) configurée pour interrompre, dans au moins un état de fonctionnement de la reconnaissance de configuration du réseau, un chemin de câble par l'élément chauffant (12) au moyen du premier élément de branchement (22) si le deuxième élément de branchement est fermé, et tenir compte d'un premier potentiel présent sur l'entrée de mesure (26) en cas de détection d'une configuration de réseau présente sur l'élément chauffant (12), l'unité de commande (28) étant configurée pour interrompre, dans le au moins un état de fonctionnement de la reconnaissance de configuration du réseau, un chemin de câble par l'élément chauffant (12) au moyen du deuxième élément de branchement (48) si le premier élément de branchement est fermé, et tenir compte d'un deuxième potentiel présent sur l'entrée de mesure (26) en cas de détection de la configuration de réseau présente sur l'élément chauffant (12), l'unité de commande (28) étant configurée pour comparer, dans le au moins un état de fonctionnement de la reconnaissance de configuration du réseau, le premier et le deuxième potentiel l'un avec l'autre et calculer une différence entre le premier et le deuxième potentiel.

2. Dispositif chauffant pour appareil ménager selon la revendication 1, **caractérisé en ce que** l'unité de commande (28) est configurée pour reconnaître, dans l'état de fonctionnement de la reconnaissance de configuration du réseau, à l'aide des potentiels présents sur l'entrée de mesure (26), la présence d'un neutre sur l'un des raccordements d'alimentation (18, 20).

3. Dispositif chauffant pour appareil ménager selon la revendication 2, **caractérisé en ce que** l'unité de commande (28) est configurée pour détecter, dans au moins un état de fonctionnement de la détection de polarité, le raccordement d'alimentation (18, 20), où se trouve le neutre.

4. Dispositif chauffant pour appareil ménager selon l'une des revendications précédentes, **caractérisé en ce que** l'unité de commande (28) est configurée pour reconnaître, dans l'état de fonctionnement de la reconnaissance de configuration du réseau, à l'aide des potentiels présents sur l'entrée de mesure (26), la présence de conducteurs de phase sur les raccordements d'alimentation (18, 20).

5. Dispositif chauffant pour appareil ménager selon l'une des revendications précédentes, **caractérisé en ce que** l'unité de commande (28) est configurée pour reconnaître, dans l'état de fonctionnement de la reconnaissance de configuration du réseau, à l'aide des potentiels présents sur l'entrée de mesure (26), au moins un défaut d'appareil.

6. Dispositif chauffant pour appareil ménager selon l'une des revendications précédentes, **caractérisé en ce que** l'unité de commande (28) est configurée pour détecter, dans l'état de fonctionnement de la reconnaissance de configuration du réseau, à l'aide de la configuration du réseau détectée, une valeur de seuil de coupure pour l'élément chauffant (12).

7. Dispositif chauffant pour appareil ménager selon l'une des revendications précédentes, **caractérisé par** au moins un élément de détection (30), lequel est configuré pour, dans l'état de fonctionnement du chauffage, la détection d'un courant de fuite de l'élément chauffant (12).

8. Dispositif chauffant pour appareil ménager selon la revendication 7, **caractérisé en ce que** l'unité de commande (28) est configurée pour, dans l'état de fonctionnement du chauffage, détecter au moins une variable dépendant du courant de fuite de l'élément chauffant (12).

9. Dispositif chauffant pour appareil ménager selon la revendication 8, **caractérisé en ce que** l'unité de commande (28) est configurée pour, dans l'état de fonctionnement du chauffage, tenir compte de la configuration du réseau présente sur l'élément chauffant (12) en cas de détection des variables dépendant du courant de fuite de l'élément chauffant (12).

10. Appareil ménager comprenant au moins un dispositif chauffant pour appareil ménager selon l'une des revendications précédentes.

11. Procédé de fonctionnement d'un dispositif chauffant pour appareil ménager comprenant au moins un élément chauffant (12), lequel présente au moins deux bornes de chauffage (14, 16), qui sont prévues à chaque fois pour un raccordement sur un d'au moins deux raccordements d'alimentation (18, 20) d'un réseau d'alimentation, avec au moins un premier élément de branchement (22), lequel est branché entre une première borne de chauffage (14) des bornes de chauffage (14, 16) et un premier raccordement d'alimentation (18) des raccordements d'alimentation (18, 20), avec au moins un deuxième élément de branchement (48), lequel est branché entre une deuxième borne de chauffage (16) des bornes de chauffage (14, 16) et un deuxième raccordement d'alimentation (20) des raccordements d'alimentation (18, 20), et avec une unité de mesure (24) qui présente au moins une entrée de mesure (26), à laquelle est appliqué un potentiel, dans le au moins un état de fonctionnement du chauffage, **caractérisé en ce que** dans au moins un état de fonctionnement de la reconnaissance de configuration du réseau, un chemin de câble est interrompu par l'élément chauffant (12) au moyen du premier élément de branchement (22) si le deuxième élément de branchement (48) est fermé, et tient compte d'un premier potentiel présent sur l'entrée de mesure en cas de détection d'une configuration du réseau présente sur l'élément chauffant (12), dans le au moins un état de fonctionnement de la reconnaissance de configuration du réseau, un chemin de câble étant interrompu par l'élément chauffant (12) au moyen du deuxième élément de branchement (22) si le premier élément de branchement (48) est fermé, et tient compte d'un deuxième potentiel présent sur l'entrée de mesure (26) en cas de détection d'une configuration du réseau présente sur l'élément chauffant (12), dans le au moins un état de fonctionnement de la reconnaissance de configuration du réseau, le premier et le deuxième potentiel étant comparés l'un avec l'autre et une différence entre le premier et le deuxième potentiel étant calculée.
